# EUROPÄISCHE PATENTSCHRIFT

(11) **EP 1 138 113 B1**
(45) Veröffentlichungstag und Bekanntmachung des Hinweises auf die Patenterteilung: **03.05.2006**
(21) Anmeldenummer: 99964387.7
(22) Anmeldetag: 01.12.1999
(51) Int. Cl.: H03B 23/00

(54) **EINRICHTUNG ZUR KORREKTUR VON NICHTLINEARTITÄTEN SPANNUNGSGESTEUERTER OSZILLATOREN IN EINEM FMCW RADARSYSTEM**
DEVICE FOR CORRECTING NON-LINEARITIES OF VOLTAGE-CONTROLLED OSCILLATORS IN A FMCW RADAR SYSTEM
DISPOSITIF DE CORRECTION D'OSCILLATEURS A TENSION VARIABLE DE NON-LINEARITE D'UN SYSTEME RADAR FMCW

(30) Priorität: 10.12.1998 DE 19857040
(43) Veröffentlichungstag der Anmeldung: 04.10.2001
(73) Patentinhaber: SIEMENS AKTIENGESELLSCHAFT, 80333 München (DE)
(72) Erfinder: ROSKOSCH, Richard, D-85521 Ottobrunn (DE); KUNERT, Martin, D-93073 Neutraubling (DE); HUSCHENBETT, Matthias, D-93057 Regensburg (DE); HEIDE, Patric, D-85579 Neubiberg (DE)
(86) Internationale Anmeldenummer: PCT/DE1999/003833
(87) Internationale Veröffentlichungsnummer: WO 2000/035076

(56) Entgegenhaltungen:
- EP-A- 0 042 641
- DE-A- 3 935 829
- DE-C- 3 938 250
- US-A- 4 468 638
- US-A- 4 499 435

## Beschreibung

Die Erfindung betrifft ein Verfahren zur Detektion und Korrektur von Nichtlinearitäten hochfrequenter, spannungsgesteuerter Oszillatoren, wie sie insbesondere in Form von Mikrowellen-Oszillatoren für Radaranwendungen in Kraftfahrzeugen eingesetzt werden.

Die Radartechnik ist für den rauhen Einsatz im Automobil oder der Industrie zum Zweck einer berührungslosen Erfassung der Entfernung, Geschwindigkeit, Beschaffenheit, Anwesenheit oder dergleichen von Objekten besonders geeignet. Funktionalität, Meßgenauigkeit und Kosten von Radarsensoren hängen dabei wesentlich vom angewandten Modulationsverfahren und der zugehörigen Radar-Signalverarbeitung ab.

Bei dem häufig zur Abstandsmessung verwendeten FMCW-Radarprinzip (FMCW = frequency modulated continous wave) hängt die Qualität des Meßwertes u. a. von der Frequenzgenauigkeit und -stabilität des Mikrowellen-Oszillators ab. Diese Größen werden in der Praxis vor allem durch Temperaturdrift, Rauschen und Nichtlinearitäten des Oszillators beeinflußt und müssen deshalb in der Regel überwacht werden.

Die berührungslose Abstands- und Geschwindigkeitsmessung mit Radar ist seit langem bekannt und entstammt der Militärtechnik. Bei dem bereits erwähnten FMCW-Verfahren, auf dessen Basis das in der EP 0 727 051 B1 beschriebene Verfahren zum Betreiben eines Radargerätes funktioniert, wird ein frequenzmoduliertes Radarsignal ausgesendet, daß phasen- bzw. frequenzverschoben empfangen wird. Die gemessene Phasen- bzw. Frequenzdifferenz, die typischerweise im kHz-Bereich liegt, ist proportional zum Objektabstand, vorausgesetzt die Frequenzmodulation erfolgt zeitlich linear. In der Praxis ist diese Voraussetzung oftmals nur unzureichend erfüllt.

Die Nichtlinearitäten bei der Frequenzmodulation werden in erster Linie durch die spannungsgesteuerten Oszillatoren verursacht, da diese bauteilebedingt eine nichtlineare Spannungs/Frequenz-Kennlinie aufweisen. Darüber hinaus zeigen diese Oszillatoren ein mehr oder weniger stark ausgeprägtes Phasenrauschen, das im Vergleich zur spannungsabhängigen Nichtlinearität wesentlich höherfrequenter ist und bei kurzen Entfernungen - der sogenannten Korrelationslänge des Radars - in der Regel vernachlässigt werden kann.

Eine Kompensation der spannungsabhängigen Nichtlinearitäten ist hingegen unbedingt erforderlich, um eine einwandfreie Objektdetektion mit der Radareinrichtung durchführen zu können. Da sich die Nichtlinearitäten beispielsweise durch Temperatur- oder Alterungseffekte ändern, muß eine Korrektur ständig angepaßt werden, um Linearitätsabweichungen im Toleranzbereich von maximal 1 % des Meßwertes zu halten.

Aus dem Stand der Technik sind entsprechende Korrekturverfahren bekannt:
- Der Oszillator kann mit einer einmalig vorbestimmten, vorverzerrten Steuerspannung angesteuert werden. Diese Methode ist jedoch nur bedingt tauglich, da Exemplarstreuungen des Oszillators sowie nachfolgende Frequenzschwankungen und Temperaturdriften konzeptbedingt nicht kompensiert werden.
- Aus dem Fachaufsatz von P. Lowbridge et al. "A Low Cost mm-Wave Cruise Control System for Automotive Applications" in Microwave Journal, October 1993, ist der Einsatz einer Regelschleife bekannt, die eine PLL-(= Phase Lock Loop-) oder AFC (= Automatic Frequency Control-) Schaltung umfaßt. Bei beiden Verfahren wird eine frequenzabhängige Referenzspannung erzeugt, die in Kombination mit einer linearen Rampe die Ansteuerspannung des Oszillators derart adaptiert, daß die Frequenzmodulation zeitlich linear verläuft. Eine derartige Regelelektronik hat jedoch den Nachteil, zu teuer und unflexibel zu sein.
- Aus der Fachveröffentlichung von Nalezinski et al. "Novel Heterodyne 24GHz FMCW Radar with High-Precision 2,4GHz SAW Reference Path" in MIOP'97 Conference Proceedings ist der Einsatz einer Referenzstrecke innerhalb der Radaranordnung bekannt, die aufgrund ihrer definierten und genau bekannten Verzögerungszeit dem störgrößenfreien Referenzsignal eines virtuellen Reflexionspunktes entspricht, dessen Entfernung durch eine Soll-Verzögerungszeit bestimmt ist. Durch Analyse und Auswertung dieses Signals ist eine Korrektur von realen Signalen mit ähnlichen Verzögerungszeiten möglich. Dieses Verfahren ist jedoch dahingehend von Nachteil, daß die zusätzliche Referenzstrecke und die ihr zugeordnete Auswerteeinheit operativ aufwendig und damit kostenintensiv sind. Letzteres ist gerade im Hinblick auf die Verwendung solcher Radarsensoren als Massenbauteil in Kraftfahrzeugen nicht akzeptabel.
- Aus der Druckschrift DE 39 35 829 A1 ist ein Linearisierungsregelkreis zur Korrektur des Frequenzganges eines spannungsgesteuerten Oszillators in einem frequenzmodulierten System bekannt. Dabei wird ein vom Oszillator abgegriffenes Frequenzsignal einem Frequenz-Spannungswandler zugeführt und das Ausgangssignal des Frequenz-Spannungswandlers auf einen Tiefpass aufgeschaltet. Der auf diese Weise erzeugte, der Frequenz proportionale Spannungswert wird schließlich einem Linearisierungsregelkreis zugeführt.

Ausgehend von der geschilderten Problematik zum Stand der Technik liegt der Erfindung die Aufgabe zugrunde, ein Verfahren zur Detektion und Korrektur von Nichtlinearitäten hochfrequenter, spannungsgesteuerter Oszillatoren anzugeben, das extrem einfach und damit kostengünstig in einen leistungsfähigen Radarsensor implementierbar ist.

Diese Aufgabe wird durch das im Anspruch 1 angegebene Verfahren gelöst. Der Kern der Erfindung liegt dabei darin, das Frequenzsignal des Oszillators über ein logisches EX-ODER-Gatter unter Aufspaltung des Frequenzsignals in ein unverzögertes und ein verzögertes Eingangssignal für das Gatter in digitale Impulse am Ausgang des EX-ODER-Gatters umzuwandeln, die mit Hilfe eines Tiefpaßfilters in einen zur Frequenz des Oszillator-Frequenzsignals proportionalen Gleichspannungswert umgewandelt werden. Damit ist die bei einer bestimmten Ansteuerspannung für den Oszillator entstehende Frequenz bekannt und kann bei Abweichung von einem Sollwert durch Generieren eines Korrekturwertes für die Frequenzsteuerung des Oszillators auf diesen Sollwert gebracht werden. Die entsprechenden Korrekturwerte sind mit an sich bekannten Kompensationsverfahren herzuleiten, wie sie beispielsweise aus dem Fachbeitrag von M. Vossiek et al. "Signal Processing Methods for Millimeterwave FMCW Radar with High Distance and Doppler Resolution" in 27^{th} European Microwave Conference 1997 bekannt sind.

Mit Hilfe des erfindungsgemäßen Verfahrens läßt sich auf der Basis einer gerätetechnisch einfachen Korrekturschaltung eine für praktische Anwendungsfälle insbesondere bei Radaranwendungen in Kraftfahrzeugen mehr als ausreichende Linearität der Frequenzmodulation erzielen.

In den Unteransprüchen sind vorteilhafte Weiterbildungen des erfindungsgemäßen Verfahrens angegeben. Im Zusammenhang mit der bevorzugter Weise vorgesehenen Kalibrierung der Frequenzdetektion und -korrektur ist festzuhalten, daß diese nicht nur im Zusammenhang mit der im Hauptanspruch angegebenen Umwandlung des Frequenzsignals in einen dazu proportionalen Gleichspannungswert über ein EX-ODER-Gatter, sondern auch ganz allgemein bei einer andersartigen Frequenz-Spannungs-Wandlung einsetzbar ist. Beispielsweise können kommerziell erhältliche, langsamere Frequenz-Spannungs-Konverter mit einer von der Taktfrequenz des Mikrocontrollers für den Radarsensor abgeleiteten Referenz-Frequenz kalibriert werden.

Nähere Ausführungen sowie Vorteile zur Erfindung sind der nachfolgenden Beschreibung entnehmbar, in der ein Ausführungsbeispiel des erfindungsgemäßen Verfahrens anhand der beigefügten Zeichnungen näher erläutert wird. Es zeigen:
Figur 1 ein Blockschaltbild eines Radarsensors mit zugeordneter Vorrichtung zur Detektion und Korrektur von Nichtlinearitäten des Radaroszillators, und
Figur 2 ein Frequenz-Spannungs-Diagramm.

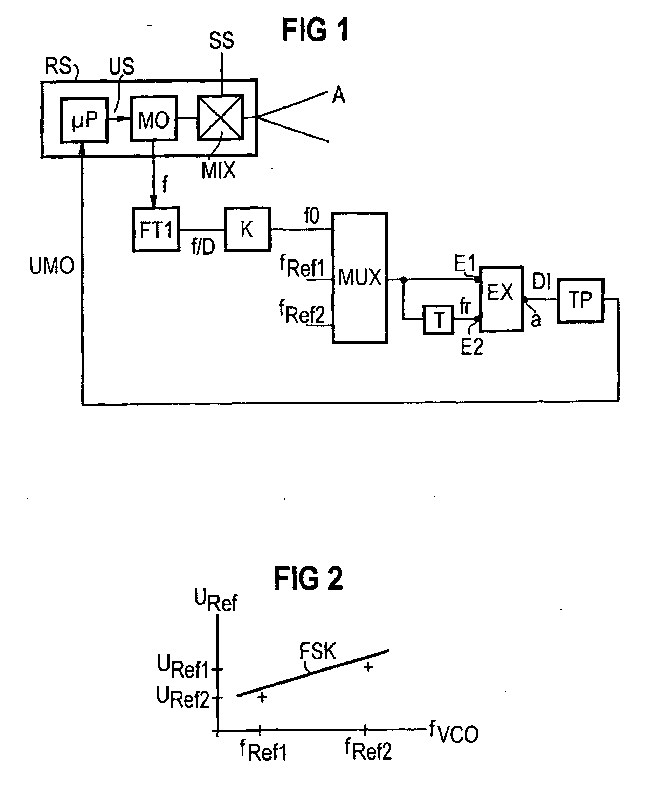

Wie in Figur 1 dargestellt ist, bildet ein konventioneller Radarsensor RS die gerätetechnische Basis zur Durchführung und Implementierung des erfindungsgemäßen Verfahrens. Der Radarsensor RS weist einen frequenzmodulierten Oszillator MO, einen Radarempfänger bzw. Mischer MIX und eine Antenne A auf. Das Sensorsignal SS liegt am Mischer MIX an und kann zur Auswertung beispielsweise in einem Abstandsradar in Kraftfahrzeugen entsprechend weiterverarbeitet werden.

Der frequenzmodulierte Oszillator MO wird von einem rampenförmigen Steuersignal US frequenzmoduliert, das von einem Mikrocontroller µP erzeugt wird. Würde das Steuersignal US streng linear sein, so würden sich aufgrund der Nichtlinearitäten der Kennlinie des Oszillators MO die eingangs erörterten Probleme ergeben. Aus diesem Grunde wird das Steuersignal US mit Hilfe des nachfolgend beschriebenen erfindungsgemäßen Verfahrens korrigiert.

So weist der Oszillator MO einen Abgriff auf, mit dessen Hilfe ein Frequenzsignal f abgegriffen wird. Dies liegt bei den ins Auge gefaßten Anwendungen im GHz-Bereich. Es wird einem Frequenzteiler FT1 zugeführt, daß das abgegriffene Frequenzsignal f um einen Vorteilerwert D in der Größenordnung von 100 bis 1000 so unterteilt, daß die Frequenz des heruntergeteilten Frequenzsignals im MHz-Bereich liegt.

Das so heruntergeteilte Frequenzsignal f/D wird in einem dem Frequenzteiler FT1 nachgeschalteten Komparator K so aufbereitet, daß seine Flanken in ihrer Steilheit erhöht werden. Das derart aufbereitete Frequenzsignal f0 wird anschließend über einen Multiplexer-Baustein MUX dem ersten Eingang E1 eines logischen EX-ODER-Gatters EX zugeführt. Gleichzeitig wird das über den Multiplexer-Baustein MUX geführte Frequenzsignal f0 zu einem Verzögerungszeitglied T geführt, das ein zum Frequenzsignal f0 verzögertes Frequenzsignal fᵥ erzeugt. Dieses wird dem zweiten Eingang E2 des EX-ODER-Gatters EX zugeführt.

Aufgrund der logischen Verknüpfung, die das EX-ODER-Gatter zwischen den Frequenzsignalen f0 und fᵥ bildet, werden am Ausgang a des EX-ODER-Gatters EX digitale Impulse DI entstehen, deren Repetitionsrate der Frequenz des heruntergeteilten Frequenzsignals f/D entspricht.

Diese digitalen Impulse DI werden einem Tiefpaßfilter TP zugeführt und von diesem in einen Gleichspannungswert UMO konvertiert, der proportional der Frequenz f des Mikrowellen-Oszillators MO ist. Somit ist die bei einem bestimmten Wert des Steuersignals US entstehende Frequenz des Oszillators bekannt und kann im Mikrocontroller µP entsprechend den bei M. Vossiek et al. (a. a. O.) angegebenen Kompensationsverfahren durch Generieren entsprechender Korrekturwerte so adaptiert werden, daß der Frequenzlauf des Oszillators MO innerhalb vorgegebener Maximalabweichungen streng linear ist.

Im Zusammenhang mit dem Verzögerungszeitglied T ist noch eine besondere Problematik zu erörtern. So zeigen kommerziell verfügbare digitale Verzögerungszeitglieder T, die typischerweise eine Signalverzögerung um eine feste Zeit von z. B. 10 bis 20 nsec des eingespeisten Signals hervorrufen, eine Exemplarstreuung und Temperaturdrift auf. Diese Ungenauigkeit der von dem Verzögerungszeitglied T hervorgerufenen Verzögerung hat eine Einschränkung der Genauigkeit der Frequenzmessung zur Folge, die vermieden werden soll. Insofern wird als zusätzliche vorteilhafte Maßnahme beim erfindungsgemäßen Verfahren eine Kalibrierung im Rahmen der Frequenzdetektion und -korrektur vorgenommen. Dabei werden zwei Referenz-Frequenzen f_{Ref1} und f_{Ref2} über den Multiplexer-Baustein MUX in die aus EX-ODER-Gatter EX und Verzögerungselement T bestehende Baugruppe eingespeist und das dabei jeweils auftretende Ausgangssignal des EX-ODER-Gatters EX über den Tiefpaßfilter TP in zugeordnete Gleichspannungswerte U_{ref1} und U_{ref2} konvertiert. Unter der Annahme einer hohen Linearität bei der Umsetzung der digitalen Impulse DI aus der Baugruppe EX-ODER-Gatter EX, Verzögerungszeitglied T und Tiefpaßfilter TP läßt sich die Frequenz-Spannungs-Kennlinie FSK der Anordnung exakt bestimmen. Dies ist in Figur 2 augenfällig dargestellt. Typischerweise läßt sich durch diese Kalibrierung der Restfehler bei der Frequenzmessung unter 1 % drücken, was für die praktische Anwendung - wie eingangs erörtert - als ausreichend gelten kann.

Die beiden Referenz-Frequenzen f_{Ref1} und f_{Ref2} liegen im übrigen im selben Frequenzbereich wie das heruntergeteilte Frequenzsignal f/D und sind zweckmäßigerweise quarzstabile Frequenzen. Letztere können beispielsweise von der Taktung des Mikrocontrollers µP abgeleitet werden.

## Patentansprüche

1. Verfahren zur Detektion und Korrektur von Nichtlinearitäten von hochfrequenten, spannungsgesteuerten Oszillatoren, insbesondere von Mikrowellen-Oszillatoren für Radaranwendungen in Kraftfahrzeugen, mit folgenden Verfahrensschritten:
- Abgreifen eines Frequenzsignals (f) vom Oszillator (MO),
- Zuführen des Frequenzsignals (f0) an den ersten Eingang (E1) eines logischen EX-ODER-Gatters (EX),
- gleichzeitiges Zuführen des Frequenzsignals (f0) zu einem Verzögerungzeitglied (T) unter Erzeugung eines zeitverzögerten Frequenzsignals (fᵥ) und Zuführen des verzögerten Frequenzsignals (fᵥ) an den zweiten Eingang (E2) des logischen EX-ODER-Gatters (EX),
- Umwandeln der am Ausgang (a) des EX-ODER-Gatters (EX) erzeugten digitalen Impulse (DI) in einen zur Frequenz (f) des Oszillator-Frequenzsignals proportionalen Gleichspannungswert (UMO) mittels eines Tiefpaßfilters (TP), und
- Generieren eines Korrekturwertes für die Frequenzsteuerung des Oszillators (MO) auf der Basis des Gleichspannungswertes (UMO) zur Einstellung der Oszillatorfrequenz (f) auf einen Sollwert.

2. Verfahren nach Anspruch 1, **dadurch gekennzeichnet, daß** das abgegriffene Frequenzsignal (f) mittels eines Frequenzteilers (FT1) um einen Vorteilerwert (D) heruntergeteilt wird.

3. Verfahren nach Anspruch 2, **dadurch gekennzeichnet, daß** das abgegriffene Frequenzsignal (f) mittels des Frequenzteilers (FT1) von einer Frequenz im GHz-Bereich auf eine Frequenz im MHz-Bereich heruntergeteilt wird.

4. Verfahren nach einem der Ansprüche 1 bis 3, **dadurch gekennzeichnet, daß** das Frequenzsignal (f/D) mittels eines Komparators (K) in seinem Flankenverlauf versteilert wird.

5. Verfahren nach einem der Ansprüche 1 bis 4, **dadurch gekennzeichnet, daß** das Frequenzsignal (f0) über einen Multiplexer-Baustein (MUX) dem EX-ODER-Gatter (EX) zugeführt wird.

6. Verfahren insbesondere nach einem der Ansprüche 1 bis 5, **dadurch gekennzeichnet, daß** zur Kalibrierung der Frequenzdetektion und -korrektur mindestens ein aus dem Radarsensor (RS) abgeleitetes Referenz-Frequenzsignal (f_{Ref1}, f_{Ref2}) in die Schaltung zur Umsetzung des Frequenzsignals (f) in den Gleichspannungswert (UMO) eingespeist wird.

7. Verfahren nach Anspruch 5 oder 6, **dadurch gekennzeichnet, daß** zur Kalibrierung der Frequenzdetektion und -korrektur zwei unterschiedliche Referenz-Frequenzsignale (f_{Ref1,} f_{Ref2}) mit Frequenzen im Bereich des Frequenzsignals (f0) über den Multiplexer-Baustein (MUX) in die Baugruppe aus EX-ODER-Gatter (EX)und Verzögerungselement (T) eingespeist und verarbeitet werden:

8. Verfahren nach einem der Ansprüche 1 bis 7, **dadurch gekennzeichnet, daß** der Korrekturwert für die Frequenzsteuerung des Oszillators (MO) mittels eines Mikrocontrollers (µP) erzeugt wird.

9. Verfahren nach Anspruch 7 und 8, **dadurch gekennzeichnet, daß** die Referenz-Frequenzsignale (f_{Ref1}, f_{Ref2}) von im Mikrocontroller (µP) zur Verfügung stehenden Referenzsignalen abgeleitet werden.

## Claims

1. Method for detecting and correcting non-linearities in radio-frequency, voltage-controlled oscillators, in particular in microwave oscillators for radar applications in motor vehicles, having the following method steps:
- a frequency signal (f) is tapped off from the oscillator (MO),
- the frequency signal (f0) is supplied to the first input (E1) of a logic EXOR gate (EX),
- the frequency signal (f0) is simultaneously supplied to a delay element (T), producing a delayed frequency signal (fᵥ), and the delayed frequency signal (fᵥ) is supplied to the second input (E2) of the logic EXOR gate (EX),
- the digital pulses (DI) produced at the output (a) of the EXOR gate (EX) are converted into a DC voltage value (UMO) proportional to the frequency (f) of the oscillator frequency signal using a low pass filter (TP), and
- a correction value for the frequency control of the oscillator (MO) is generated on the basis of the DC voltage value (UMO) in order to set the oscillator frequency (f) to a nominal value.

2. Method according to Claim 1, **characterized in that** the frequency signal (f) tapped off is divided down by a prescaler value (D) using a frequency divider (FT1).

3. Method according to Claim 2, **characterized in that** the frequency signal (f) tapped off is divided down from a frequency in the GHz range to a frequency in the MHz range using the frequency divider (FT1).

4. Method according to one of Claims 1 to 3, **characterized in that** the edge profile of the frequency signal (f/D) is steepened using a comparator (K).

5. Method according to one of Claims 1 to 4, **characterized in that** the frequency signal (f0) is supplied to the EXOR gate (EX) via a multiplexer chip (MUX).

6. Method, in particular according to one of Claims 1 to 5, **characterized in that**, for calibrating the frequency detection and correction, at least one reference frequency signal (f_{Ref1}, f_{Ref2}) derived from the radar sensor (RS) is fed into the circuit in order to convert the frequency signal (f) into the DC voltage value (UMO).

7. Method according to Claim 5 or 6, **characterized in that**, for calibrating the frequency detection and correction, two different reference frequency signals (f_{Ref1}, f_{Ref2}) having frequencies in the range of the frequency signal (f0) are fed into the module comprising EXOR gate (EX) and delay element (T) via the multiplexer chip (MUX) and are processed.

8. Method according to one of Claims 1 to 7, **characterized in that** the correction value for the frequency control of the oscillator (MO) is produced using a microcontroller (µP).

9. Method according to Claim 7 and 8, **characterized in that** the reference frequency signals (f_{Ref1}, f_{Ref2}) are derived from reference signals available in the microcontroller (µP).

## Revendications

1. Procédé de détection et de correction de non-linéarités d'oscillateurs à haute fréquence commandés par la tension, en particulier d'oscillateurs à micro-ondes pour des applications de radars dans des véhicules automobiles, comportant les étapes de procédé suivantes:
- relever un signal de fréquence (f) de l'oscillateur (MO),
- envoyer le signal de fréquence (f0) à la première entrée (E1) d'une grille logique EX-OU (EX),
- envoyer simultanément le signal de fréquence (f0) à un organe retardateur (T) en produisant un signal de fréquence retardé (fᵥ) et en envoyant le signal de fréquence retardé (fᵥ) à la deuxième entrée (E2) de la grille logique EX-OU (EX),
- transformer l'impulsion numérique (DI) produite à la sortie (a) de la grille EX-OU (EX) en une valeur de tension continue (UMO) proportionnelle à la fréquence (f) du signal de fréquence de l'oscillateur, au moyen d'un filtre passe-bas (TP), et
- générer une valeur de correction pour la commande de fréquence de l'oscillateur (MO) sur la base de la valeur de tension continue (UMO) pour régler la fréquence (f) de l'oscillateur sur une valeur de consigne.

2. Procédé suivant la revendication 1, **caractérisé en ce que** le signal de fréquence (f) relevé est divisé, au moyen d'un diviseur de fréquence (FT1), avec une valeur prédéfinie de diviseur (D).

3. Procédé suivant la revendication 2, **caractérisé en ce que** le signal de fréquence relevé (f) est divisé, au moyen du diviseur de fréquence (FT1), d'une fréquence située dans la zone des GHz pour obtenir une fréquence dans la zone des MHz.

4. Procédé suivant l'une des revendications 1 à 3, **caractérisé en ce que** le signal de fréquence (f/D), à l'aide d'un comparateur (K), présente un tracé de flancs à pente plus verticale.

5. Procédé suivant l'une des revendications 1 à 4, **caractérisé en ce que** le signal de fréquence (f0) est envoyé par l'intermédiaire d'un constituant multiplexeur (MUX), à la grille EX-OU (EX).

6. Procédé, en particulier suivant l'une des revendications 1 à 5, **caractérisé en ce que**, pour le calibrage de la détection et la correction de fréquence, au moins un signal de fréquence de référence (f_{Ref1}, f_{Ref2}), provenant du détecteur de radar (RS), est mis en mémoire dans le circuit pour transformer le signal de fréquence (f) en la valeur de tension continue (UMO).

7. Procédé suivant la revendication 5 ou 6, **caractérisé en ce que**, pour le calibrage de la détection et la correction de fréquence, deux signaux de fréquence de référence (f_{Ref1}, f_{Ref2}) différents, comportant des fréquences dans la zone du signal de fréquence (f0), sont, par l'intermédiaire du constituant multiplexeur (MUX), mis en mémoire dans le groupe constitutif composé de la grille EX-OU (EX) et de l'élément retardateur (T) et y sont interprétés.

8. Procédé suivant l'une des revendications 1 à 7, **caractérisé en ce que** la valeur de correction pour la commande de fréquence de l'oscillateur (MO) est produite au moyen d'un microcontrôleur (µP).

9. Procédé suivant la revendication 8, **caractérisé en ce que** les signaux de fréquence de référence (f_{Ref1}, f_{Ref2}) sont dérivés de signaux de référence disposés dans le microcontrôleur (µP).
